# EUROPEAN PATENT APPLICATION

(11) **EP 1 265 355 A2**
(43) Date of publication of application: **11.12.2002**
(21) Application number: 02252885.5
(22) Date of filing: 24.04.2002
(51) Int. Cl.: H03F 1/52

(54) **Overcurrent protection in a car stereo system**

(30) Priority: 08.06.2001 JP 2001174870
(71) Applicant: Pioneer Corporation, Meguro-ku, Tokyo (JP)
(72) Inventor: Suenaga, Shoji, c/o Pioneer Corporation, Kawagoe-shi, Saitama (JP)
(74) Representative: Haley, Stephen

(57) **Abstract**

Electronic equipment a terminal for inputting or outputting signals to be used in a circuit provided in electronic equipment, and a fuse provided on a signal ground line between the terminal and the circuit.

## Description

The present invention generally relates to electronic equipment having an overcurrent protection fuse, and more particularly to electronic equipment having a fuse provided on a signal ground line.

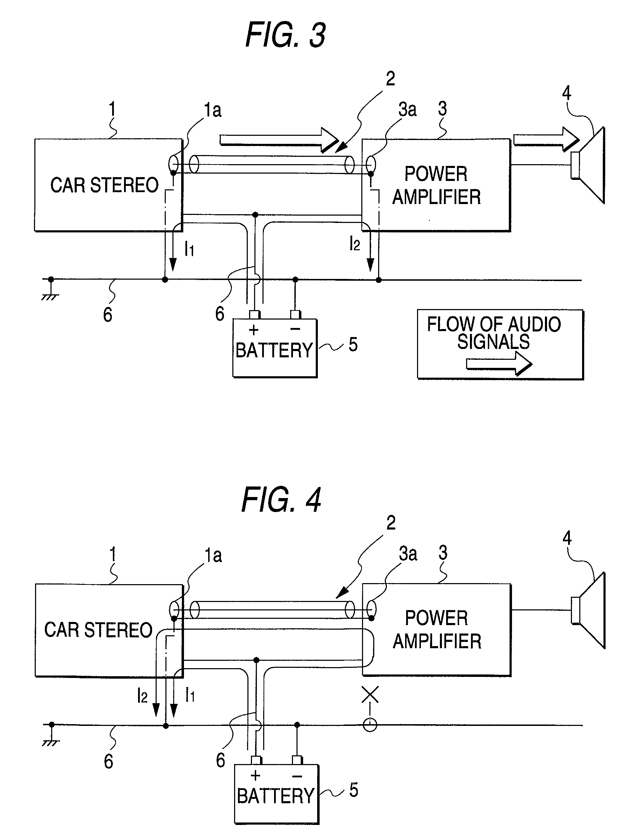

In recent years, users occasionally use car stereos by respectively connecting external power amplifiers thereto so as to enjoy audio from the car stereos with higher quality at a larger volume. In this case, audio signals are amplified by an amplifier circuit provided in the power amplifier. Then, sounds represented by the amplified signals are outputted from speakers. That is, as shown in FIG. 3, the car stereo outputs audio signals from a pre-amplifier output terminal 1a. The audio signals are transmitted to the power amplifier 3 through an RCA cable 2 connected between this pre-amplifier output terminal 1a and an input terminal 3a of the power amplifier 3. Subsequently, the power amplifier 3 amplifies the audio signal, which is transmitted from the car stereo, at an internal amplifier circuit thereof and outputs the amplified signal to the speaker 4. Consequently, a user can enjoy sounds represented by the power amplifier 3.

Meanwhile, when a user uses both of a car stereo and a power amplifier in a car, it is necessary to connect the power line (corresponding to the positive terminal (+)) and the ground line (corresponding to the negative terminal (-)) of a battery to each of the car stereo and the power amplifier. However, because it is usual that an operation of connecting this battery thereto is performed by using power cables 6, there is a fear that miswiring may occur.

Usually, the car stereo and the power amplifier are constructed in such a way as not to operate even when miswiring occurs in the power cables 6. However, the car stereo and the power amplifier may operate when power or a ground is supplied thereto from a path other than the power cables 6. Hereinafter, a representative example of this is described with reference to FIG. 4. FIG. 4 illustrates the case that the power cable 6 serving as the ground line to be connected to the power amplifier 3 of FIG. 3 is not connected thereto. In this case, the power amplifier 3 is not supplied with a ground, because the power cable 6 serving as the ground line is not connected thereto. However, as illustrated in FIG. 4, the grounds of the car stereo 1 and the power amplifier 3 are connected to each other through RCA cable 2. Therefore, the power amplifier 3 is connected to the ground line through the RCA cable 2 and the car stereo 1. Consequently, although the power cable 6 serving as the ground line is not connected to the power amplifier 3 shown in FIG. 4, this power amplifier 3 normally operates by utilizing a ground supplied thereto through the RCA cable 2.

However, in this case, electric current I₂ consumed by the power amplifier 3 cannot return directly to the battery 5 through the power cable 6, as illustrated n FIG. 3. Thus, the current I₂ returns to the battery 5 through the RCA cable 2 and the car stereo 1, as illustrated in FIG. 4. Therefore, in addition to the current I₁ consumed by the car stereo 1, the electric current I₂ additionally flows through the car stereo 1.

Because the current I₁ is a known current for the car stereo 1, a sufficient current capacity is ensured at a design stage. On the other hand, the current I₂ is an unknown current, which is caused by miswiring, for the car stereo 1. Moreover, the current I₂ flows through a signal ground pattern constituted by a relatively thin pattern. Thus, a sufficient current capacity is not ensured for the current I₂. Therefore, in the car stereo 1, a thin part of the signal ground pattern provided therein, that is, a part having a small current capacity is burnt out owing to the current I₂. This causes a fault of the stereo. Especially, when all currents to be passed through electronic equipment, such as the power amplifier 3, which consumes large current, flow thereinto, this inflow causes the breakage of electronic components in addition to the burning-out of the signal ground pattern.

An object of the invention is to solve the aforementioned problem.

To achieve this objection, according to the invention, there is provided electronic equipment that comprises a terminal for inputting or outputting signals to be used in a circuit provided therein. This terminal is connected to the circuit through at least a signal line and a signal ground line. The electronic equipment further comprises a fuse provided on the signal ground line.

In the Drawings;
FIG. 1 is a view illustrating a signal ground pattern provided in the vicinity of a pre-amplifier output terminal of a car stereo according to an embodiment of the invention;
FIG. 2 is a view illustrating a signal ground pattern provided in the vicinity of a pre-amplifier output terminal of a car stereo according to a modification of the embodiment of the invention;
FIG. 3 is a view illustrating the relation between a car stereo and a power amplifier in the case that power supply wiring is normally done; and
FIG. 4 is a view illustrating the relation between a car stereo and a power amplifier in the case that a power cable serving as a ground line of the power amplifier is not wired.

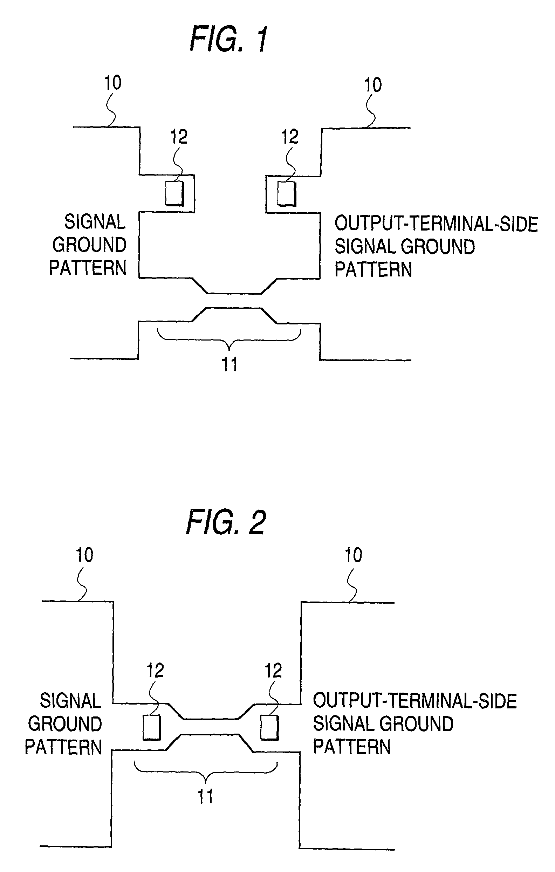

Hereinafter, an embodiment of the invention is described with reference to FIG. 1. FIG. 1 is a view illustrating a signal ground pattern provided in the vicinity of a pre-amplifier output terminal of a car stereo.

As shown in FIG. 1, this car stereo has a pattern fuse 11 formed into such a shape that this fuse is burnt out when electric current, the amount of which is equal to or more than a predetermined value, flows through a signal ground pattern provided in the vicinity of the pre-amplifier output terminal. Further, this car stereo has solder lands 12 formed on the signal ground patterns 10 provided in the vicinity of the pattern fuse 11 so that a chip fuse, whose current capacity is equal to or more than that of the pattern fuse, can be attached therebetween.

Thus, in this car stereo, even when a miswired power amplifier is connected thereto, electric current consumed by the power amplifier inevitably flows through the pattern fuse 11 provided in the vicinity of the pre-amplifier output terminal. When overcurrent, the amount of which is equal to or more than that of consumption current in the case of ordinary use, flows therethrough, the pattern is melted by heat. Consequently, at each generation of overcurrent, the pattern fuse 11 is inevitably melted. Hence, this car stereo can prevent electric current consumed by the power amplifier 3 from flowing thereinto. Thus, important patterns and electronic components provided therein can be protected. Incidentally, similar effects can be obtained by using a retrofit fuse, such as a chip fuse, instead of the pattern fuse.

Further, this car stereo has a pattern fuse formed in the vicinity of a terminal so as to be connected to another piece of electronic equipment. Thus, a failure component can easily be located. Moreover, the cause of the failure can be identified to a certain extent. That is, when the fuse pattern is melted in spite of the fact that no failures occur in this car stereo itself, there is a good possibility that overcurrent is generated because the ground line is not connected to one of the car stereo and the power amplifier. Therefore, in such a case, the recurrence of the failure can be prevented by urging a user to recheck whether the power cables are connected to each of the car stereo and the power amplifier.

Furthermore, this car stereo has solder lands 12, between which a retrofit chip fuse is attached in the proximity of the fuse pattern 11. Thus, this car stereo can easily be repaired. Moreover, this product uses the chip fuse only when the pattern fuse is melted. Consequently, the cost of components of the product can be held down.

FIG. 2 shows a modification of this embodiment in the case that the solder lands 12 are formed on the lines of the pattern fuses 11 so as to attach the chip fuse therebetween. Thus, in addition to the aforementioned effects, this modified car stereo has an additional effect that the area of parts, which are respectively occupied by the solder lands 12, of the pattern can be reduced.

Incidentally, although the car stereo has been described by way of example in the foregoing description of this embodiment, the scope of application of the invention is not limited thereto. It is sufficient that the electronic equipment of the invention has a terminal to be connected to another piece of electronic equipment, and that the electronic equipment needs to be connected to a ground line serving as a power cable from the power supply.

As described above, according to the electronic equipment of the invention, a fuse is inserted on the signal ground line to be connected to an input/output terminal that is connected to another piece of electronic equipment. Consequently, an overcurrent, which is generated owing to miswiring from a power supply, can be restrained from passing through a signal ground line and affecting another piece of electronic equipment.

## Claims

1. Electronic equipment comprising:
a terminal for inputting or outputting signals to be used in a circuit provided therein, said terminal being connected to said circuit through at least a signal line and a signal ground line; and
a fuse provided on said signal ground line.

2. Electronic equipment according to claim 1, wherein said fuse comprises a chip fuse.

3. Electronic equipment according to claim 1, wherein said electronic equipment comprises a car stereo.
